Europäisches Patentamt

European Patent Office

Office européen des brevets

(11) Publication number: **0 039 618**
A1

# EUROPEAN PATENT APPLICATION

(21) Application number: **81301992.4**

(22) Date of filing: **06.05.81**

(51) Int. Cl.³: **G 01 R 1/36, H 02 H 3/04,** **H 02 H 3/20**

(30) Priority: **07.05.80 GB 8015150**

(43) Date of publication of application: **11.11.81** **Bulletin 81/45**

(84) Designated Contracting States: **DE FR IT**

(71) Applicant: **The General Electric Company Limited, 1 Stanhope Gate, London W1A 1EH (GB)**

(72) Inventor: **Priestley, Alan Clifford, 5 Barnes Avenue, Heaton Mersey, Stockport Cheshire (GB)**
Inventor: **Greenhalgh, Keith, 301 Burnly Road, Rawtenstall, Rossendale Lancashire (GB)**
Inventor: **Leaver, Robert, 8 Brookside Road Gatley, Cheadle Cheshire (GB)**

(74) Representative: **Pope, Michael Betram Wingate, The General Electric Company Limited Central Patent Department Hirst Research Centre East Lane, Wembley Middlesex HA9 7PP (GB)**

(54) **Measuring instruments.**

(57) A multi-range portable measuring instrument in which the indicator (4) is protected from overload, at least for some of its ranges, by the operation of an electromagnetic relay (16) whose energising coil is connected between input terminals (1, 2) of the instrument and break contacts (10) of which are also connected in the input path. The relay is arranged to be energised when the voltage applied to the input terminals exceeds a predetermined value.

The present invention relates to measuring instruments.

In particular, although not exclusively, the invention relates to overload protection arrangements for portable multirange moving coil measuring instruments.

Prior protection arrangements have been based either on a mechanical trip mechanism actuated by the pointer of the instrument when it passes the end of the scale, or on a protection circuit driven by a battery housed within the instrument.

On the one hand the mechanical trip mechanism is difficult to manufacture and is variable in performance, with a relatively long operating time, while on the other hand the internally powered protection circuit depends wholly on the performance of the battery, which can become discharged and fail to operate the trip circuit when required.

According to one aspect of the present invention in a measuring instrument comprising a pair of input terminals and an indicator, there are provided an electromagnetic relay and electric circuit means connecting said relay between said input terminals, a pair of break contacts of said relay being connected between one of said input terminals and said indicator, said circuit means being arranged to energise said relay in response to the application to said input terminals of a voltage of greater than a predetermined value.

According to another aspect of the present invention in a portable multirange measuring instrument comprising a pair of input terminals, an indicator, and range switching means interconnecting said terminals and said indicator, there are provided an electromagnetic relay and electric circuit means connecting said relay between said input terminals, a pair of break contacts of said relay being connected between one of said input terminals and said indicator, and said circuit means being arranged to energise said relay in response to the application to said input terminals of a voltage of greater than a predetermined value and thereby disconnect said indicator from said input terminal.

Preferably said electric circuit means is arranged to connect said relay between said input terminals only when some of the ranges of the instrument are selected.

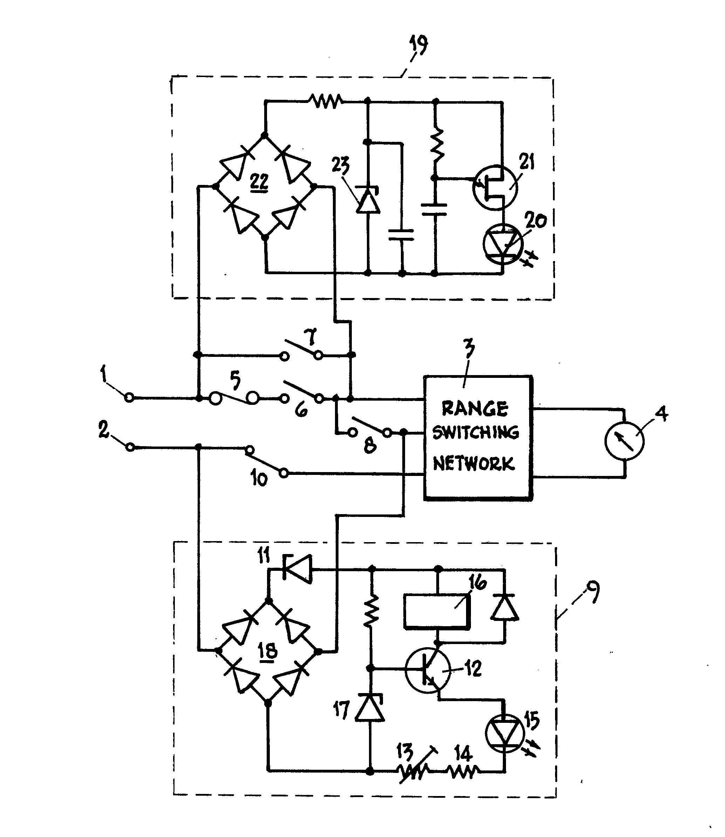

A multirange measuring instrument in accordance with the present invention will now be described by way of example with reference to the accompanying drawing, which shows the instrument diagrammatically.

Referring to the drawing, the instrument has a pair of terminals 1 and 2 which are arranged to be connected by way of a range switching network 3 to an indicator 4, which may for example be a conventional moving coil meter movement, as shown, but which may alternatively be a digital display. The range switching network 3 may include the resistors, rectifiers and batteries (not shown) conventionally provided to enable the indicator 4 to be used for a plurality of different current and voltage ranges, both A.C. and D.C. and for measuring resistance.

The terminal 1 is connected into the network 3 by way of a fuse 5 and a set of "make" contacts 6 of the range switch (not shown), this fuse 5 and the contacts 6 being arranged to be shorted when required by another set of "make" contacts 7 of the range switch. The terminal 1 is connected directly into the range switching network 3 for A.C. or D.C. voltage ranges above, say, 25 volts full scale, whereas for lower voltage ranges and for current and resistance ranges it is connected to the network 3 by way of another set of "make" contacts 8, which also connect the terminal 1 to an overload trip circuit 9. It will be appreciated that for the higher voltage ranges the network 3 will include series resistors of appreciable values, of the order of tens of kilohms or more, which will serve to protect the indicator 4 from damage by excessive voltages applied between the terminals 1 and 2, whereas for the other ranges no such protection will be afforded.

For these other ranges the circuit 9 provides protection against excessive voltages by operating a set of "break" contacts 10 between the terminal 2 and the network 3, as follows. If the voltage applied between the terminals 1 and 2, when the contacts 8 are closed, exceeds the breakdown voltage of a zener diode 11, which voltage may be sixteen volts, this diode conducts and current can flow to the base and collector electrodes of a transistor 12 biasing this transistor into conduction. Consequently current will flow in the emitter circuit of the transistor 12, through resistors 13 and 14 and a light-emitting diode 15, causing this diode 15 to emit light and thus indicating that an overload condition exists. If the overload voltage exceeds a predetermined value the consequent value of current flow through the collector-emitter path of the transistor 12 energises a relay 16, whose contacts 10 then disconnect the terminal 2 from the network 3 so long as that value of overload voltage is exceeded. A zener diode 17 in conjunction with resistor 14 and variable resistor 13 effectively permits the setting up of an upper limit to the value of current passed by the transistor 12. A bridge rectifier 18 enables the overload trip circuit 9 to function, if required, for either polarity of input or for an alternating input voltage.

-5-

A circuit 19 is connected across the fuse 5 and the contacts 6 to give an indication if the fuse 5 should blow. If it does, any dangerous voltage arising across the fuse 5 will energise a light emitting diode 20 by way of a unijunction transistor 21 and a rectifier bridge 22. For certain ranges such as high current ranges the fuse 5 will be short-circuited by the contacts 7. A zener diode 23 is provided to limit any voltage applied to the transistor 21 and the diode 20 to, say, ten volts.

The range switching network 3 may include one or more amplifiers (not shown) for the more sensitive ranges, and one or more extra pairs of contacts (not shown) may be operated when the relay 16 is energised to short circuit the input or inputs to these amplifiers if required.

0039618

1.      A measuring instrument comprising a pair of input terminals and an indicator, wherein there are provided an electromagnetic relay and electric circuit means connecting said relay between said input terminals, a pair of break contacts of said relay being connected between one of said input terminals and said indicator, and said circuit means being arranged to energise said relay in response to the application to said input terminals of a voltage of greater than a predetermined value.

2.      A portable multirange measuring instrument comprising a pair of input terminals, an indicator, and range switching means interconnecting said terminals and said indicator, wherein there are provided an electromagnetic relay and electric circuit means connecting said relay between said input terminals, a pair of break contacts of said relay being connected between one of said input terminals and said indicator, and said circuit means being arranged to energise said relay in response to the application to said input terminals of a voltage of greater than a predetermined value and thereby disconnect said indicator from said input terminal.

3.      A measuring instrument in accordance with Claim 2 wherein said electric circuit means is arranged to connect said relay between said input terminals only when some of the ranges of the instrument are selected.

4.      A measuring instrument in accordance with any preceding claim wherein there are provided means to give an indication when said relay is energised.

5.      A measuring instrument in accordance with Claim 4 wherein said means to give an indication comprises a light-emitting diode.

6.      A measuring instrument in accordance with any one of Claims 1, 2 and 3 wherein a fuse is connected in series between one of said input terminals and said indicator, and there are provided further electric circuit means to give an indication if the fuse becomes open-circuit.

7. A measuring instrument in accordance with Claim 6 wherein the means to give an indication includes a light-emitting diode.

8. A measuring instrument in accordance with Claim 6 or Claim 7 wherein there are provided means to limit the voltage applied to said further electric circuit means.

9. A measuring instrument in accordance with Claim 8 wherein said voltage limiting means comprises a zener diode.

**European Patent Office**

**EUROPEAN SEARCH REPORT**

003 9618

EP 81 30 199

| Category | Citation of document with indication, where appropriate, of relevant passages | Relevant to claim |
|---|---|---|
| | US - A - 3 024 388 (F.H. BLITCHINGTON et al.)<br><br>* Column 1, lines 68-72; column 2; column 3, lines 1-46; figure * | 1,2,8 |
| | US - A - 3 463 966 (C.E. EVANS)<br><br>* Column 1, lines 14-38; column 2, lines 47-59; figure * | 1,2 |
| | ELECTRONIQUE & APPLICATION INDUSTRIELLE, no. 259, 1978, PARIS (FR)<br>M. PETILLON: "Millivoltmètre 50KHz à 50 MHz", pages 14-16<br><br>* Page 15, left-hand column and first half of the column in the middle; figures 2 and 3 * | 1,2,4, 5 |
| | EP - A - 0 007 867 (J. LEWINER et al.)<br><br>* Abstract and figure 2 * | 6,7 |
| | DE - A - 2 551 447 (DEUTSCHE BUNDESBAHN)<br><br>* Page 10, second part; page 7, first half; figure 1 * | 6,7 |
| A | DE - B - 1 196 773 (HERRMANN K.G.)<br><br>* Column 3, lines 58-68; column 4, lines 1-37; figure 1 * | 1,2 |

**DOCUMENTS CONSIDERED TO BE RELEVANT**

**CLASSIFICATION OF THE APPLICATION (Int. Cl.³)**

G 01 R 1/36
H 02 H 3/04
       3/20

**TECHNICAL FIELDS SEARCHED (Int. Cl.³)**

G 01 R  1/36
        15/12
H 02 H  3/04
        3/20

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 05.08.1981 | KUSCHBERT |

EPO Form 1503.1  06.78